# EUROPEAN PATENT APPLICATION

(11) **EP 2 584 613 A1**
(43) Date of publication of application: **24.04.2013**
(21) Application number: 11795800.9
(22) Date of filing: 16.06.2011
(51) Int. Cl.: H01L 31/042, C08K 3/36, C08K 5/29, C08L 27/12

(54) **WEATHERABLE BACKSHEET FOR SOLAR CELL MODULE**

(30) Priority: 16.06.2010 JP 2010137131
(71) Applicant: Daikin Industries, Ltd., Osaka 530-8323 (JP)
(72) Inventor: GOBOU Kenji, Kita-Ku, Osaka-Shi Osaka 530-8323 (JP); NAKAGAWA Hideto, Kita-Ku, Osaka-Shi Osaka 530-8323 (JP); YAMAMOTO Yoshihisa, Kita-Ku, Osaka-Shi Osaka 530-8323 (CN)
(74) Representative: HOFFMANN EITLE
(86) International application number: PCT/JP2011/063790
(87) International publication number: WO 2011/158898

(57) **Abstract**

Provided is a weatherable backsheet for solar cell modules which comprises a cured coating film and a water-impermeable sheet, the cured coating film having improved secondary adhesion to the water-impermeable sheet. The backsheet is produced using a coating composition having a prolonged usable life, and film blocking phenomenon during the production can be avoided. The weatherable backsheet for solar cell modules comprises a water-impermeable sheet and a cured coating film layer formed on at least one surface thereof, the coating film layer comprising a cross-linked product of a coating composition which comprises a hydroxylated fluoropolymer and silicon oxide particles having an average primary-particle diameter of 0.1 to 30 µm.

## Description

### TECHNICAL FIELD

The present invention relates to a weatherable backsheet for solar cell modules, a solar cell module produced using the backsheet, and a solar panel.

### BACKGROUND ART

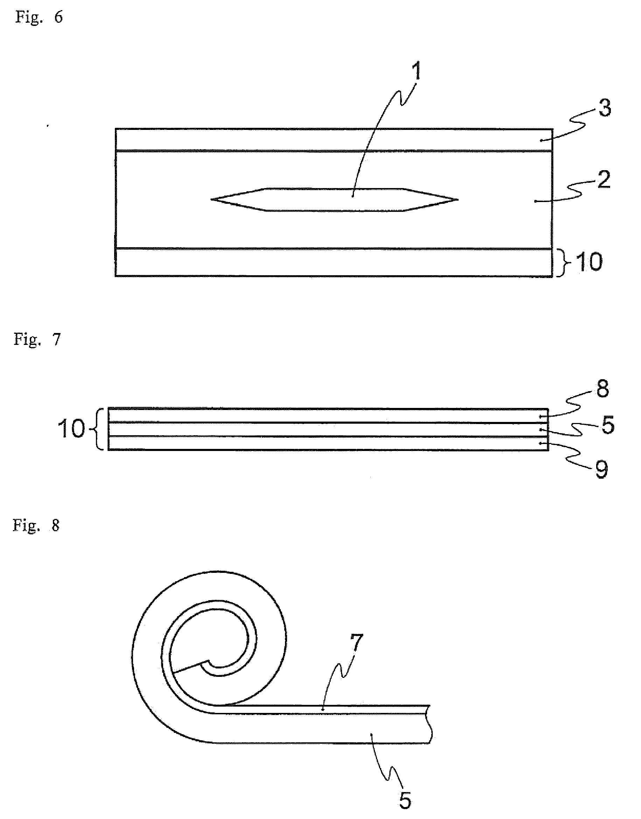

A solar cell module has, generally, a structure in which a solar cell 1 is sealed in a sealant layer 2 and the sealant layer 2 is sandwiched between a surface layer 3 made of glass or a transparent resin and a backsheet 10, as illustrated in Fig. 6. As a sealant, an ethylene/vinyl acetate copolymer (EVA) is used.

In the solar cell module, the backsheet 10 functions not only to improve mechanical strength of the module, but also to prevent ingress of moisture (water vapor) into the sealant layer.

As illustrated in Fig. 7, the backsheet 10 contains a water-impermeable sheet 5 to provide a water vapor-barrier property and a protective layer 8 such as a resin sheet and a cured coating film layer which is formed on one surface of the water-impermeable sheet. A protective layer 9 may be formed on the other surface of the water-impermeable sheet 5.

As an ingredient of the water-impermeable sheet 5, Si-deposited polyesters (Si-deposited PET), which are excellent in water-impermeability, and metals such as aluminum and stainless-steel may be used. The water-impermeable sheet generally has a thickness of 10 to 20 µm.

The protective layers 8 and 9 are required to have properties such as weather resistance, electrical insulation property, flame retardance, and design property. If the backsheet is formed by sticking a resin sheet, a polyvinyl fluoride (PVF) sheet is used. As a sheet for the protective layer of the sealant layer 2 side, a polyethylene sheet may be used.

If a resin sheet is used, however, the resin sheet generally needs to have a thickness of 20 to 100 µm to provide the required properties such as weather resistance and electrical insulation property. Thus, a further lighter protective layer is required, from the view point of the weight.

Thus, a cured coating film layer which is formed by a resin coating composition is suggested in place of the resin sheet (see Patent Literature 1 and Patent Literature 2, for example).

In Patent Literature 1, an epoxy resin coating composition is used as a resin coating composition. An epoxy resin, however, is not resulting in practical use, since it provides an insufficient weather resistance.

Patent Literature 2 proposes a two-layer weatherable backsheet in which a PVdF coating composition obtained by adding a specific amount of a tetraalkoxysilane or a partial hydrolysate thereof to a PVdF having no functional group is applied to a metal base (water-impermeable sheet). The single PVdF coating composition is inferior in adhesion to EVA, which is a sealant, since the PVdF has no functional group. In Patent Literature 2, this problem is remedied by adding a specific amount of a tetraalkoxysilane or a partial hydrolysate thereof to the coating composition and adding the tetraalkoxysilane or the partial hydrolysate to the interface between the coating and EVA. However, the tetraalkoxysilane or the partial hydrolysate thereof is concentrated at the interface between the PVdF coating film and the EVA. Thus, the adhesion of the PVdF coating with the metal base is still not improved. Furthermore, the PVdF is crystalline, has no functional group, and thereby requires calcination for 20 to 120 seconds at temperatures of 200°C to 300°C in order to form a coating film. Therefore, application of the PVdF coating composition to a water-impermeable sheet which is not made of metal is difficult.

In order to solve the problems, a weatherable backsheet for solar panels in which a cured coating film layer containing a hydroxylated fluoropolymer coating composition is formed on at least one surface of the water-impermeable sheet is proposed. This backsheet is excellent in adhesion to all kinds of water-impermeable sheets (see Patent Literature 3 and Patent Literature 4, for example).

The adhesion of the cured coating film layer to the water-impermeable sheet which is evaluated in Patent Literature 3 is the adhesion after drying of the coating (primary adhesion). Patent Literature 3 does not mention the adhesion in an environment of the site where the solar panel is actually installed (secondary adhesion: in general, the adhesion after the accelerated weathering test). With regard to other compounding agents, there is only a general statement that pigments such as titanium oxide for a white coating composition and carbon black for a black coating composition can be mixed.

Patent Literature 4 points to colloidal silica as an example of other compounding agents and says that colloidal silica may be mixed so as to improve the electrical insulation property and flame retardance and to decrease the glossiness. However, it does not mention physical properties such as secondary adhesion, and only shows Cobo-o-sil TS 720 (produced by Cabot Corporation.) as a specific example of favorable hydrophobic modified silicas.

### CITATION LIST

### Patent Literature

Patent Literature 1: JP H7-176775 A
Patent Literature 2: JP 2004-214342 A
Patent Literature 3: JP 2007-035694 A
Patent Literature 4: US 2008/0264484

### SUMMARY OF INVENTION

### Technical Problem

Patent Literatures 3 and 4 suggest a step of applying a polymer solution. However, they do not mention the usable life of the coating composition and various problems which arise in a general applying process, such as pressure bonding of films during the production.

The present inventors examined the adhesion of backsheet for solar cell modules disclosed in Patent Literatures 3 and 4, and thereby found that though the primary adhesion is acceptable, the secondary adhesion has room for improvement. They continued the examination and thus completed the present invention.

Namely, the present invention aims to provide a weatherable backsheet for solar modules in which a cured coating film has improved secondary adhesion to a water-impermeable sheet, a coating composition has prolonged usable life, and pressure bonding of films during the production can be avoided.

Other problems are described based on a specific embodiment.

### Solution to Problem

The present invention relates to a weatherable backsheet for solar cell modules including a water-impermeable sheet and a cured coating film layer formed on at least one surface of the water-impermeable sheet, the cured coating film layer containing a cross-linked product of a coating composition which contains a hydroxylated fluoropolymer and silicon oxide particles having an average primary-particle diameter of 0.1 to 30 µm.

The structure of the weatherable backsheet of the present invention may be: a two-layer structure in which a cured coating film layer containing a hydroxylated fluoropolymer coating composition which contains silicon oxide particles is formed on only one surface of the water-impermeable sheet; a three-layer structure in which the cured coating film layer is formed on both surfaces of the water-impermeable sheet; or a three-layer structure in which the cured coating film layer is formed on one surface of the water-impermeable sheet and a cured coating film layer of silicon oxide particles and/or a fluoropolymer coating composition which has no curable functional group, a fluoropolymer sheet, a polyester sheet, or a coating film containing polyester coating composition (hereinafter, also referred to as "other sheet or coating film") is formed on the other surface. Here, one or more intervening layers may be interposed between the water-impermeable sheet and the cured coating film layer and/or another sheet or coating film so as to achieve further improved adhesion, improved hiding, and reduced water vapor permeability. A representative example of the intervening layer is a primer layer.

The present invention also relates to a solar cell module which is a laminate including a sealant layer which has a solar cell sealed inside and contains an ethylene/vinyl acetate copolymer and the above-mentioned weatherable backsheet.

The present invention also relates to a solar panel provided with the above-mentioned solar cell module.

### Advantageous Effects of Invention

The present invention enables to provide a weatherable backsheet for solar modules in which a cured coating film has improved secondary adhesion to a water-impermeable sheet, a coating composition has prolonged usable life, and pressure bonding of the films during the production can be avoided.

Other effects are described based on a specific embodiment.

### BRIEF DESCRIPTION OF DRAWINGS

Fig. 1 is a schematic cross-sectional view of a solar cell module according to a first embodiment of the present invention.
Fig. 2 is a schematic cross-sectional view of a solar cell module according to a second embodiment of the present invention.
Fig. 3 is a schematic cross-sectional view of a solar cell module according to a third embodiment of the present invention.
Fig. 4 is a schematic cross-sectional view of a solar cell module according to a fourth embodiment of the present invention.
Fig. 5 is a schematic cross-sectional view of a solar cell module according to a fifth embodiment of the present invention.
Fig. 6 is a schematic cross-sectional view of a conventional solar cell module.
Fig. 7 is a schematic cross-sectional view of a conventional weatherable backsheet of a solar cell module.
Fig. 8 is an explanation drawing illustrating adhesion between an incompletely cured coating film layer and a water-impermeable sheet without a cured coating film layer of the weatherable backsheet according to the present invention.

### DESCRIPTION OF EMBODIMENT

In the weatherable backsheet for solar modules of the present invention, a cured coating film layer containing a cross-linked product of a coating composition containing hydroxylated fluoropolymer and silicon oxide particles having an average primary-particle diameter of 0.1 to 30 µm is formed on at least one surface of the water-impermeable sheet.

Examples of the hydroxylated fluoropolymer include a polymer obtained by introducing a hydroxyl group into a fluoropolymer. Examples of the fluoropolymer include resinous polymers that have a clear melting point, elastomeric polymers that have rubber elasticity, and thermoplastic elastomeric polymers that have a quality between the resinous polymer and the thermoplastic polymer.

Generally, a hydroxyl group is introduced to a fluoropolymer by copolymerization with a hydroxylated monomer.

Examples of the hydroxylated monomer include, but are not limited to, the following monomers.

Examples of the hydroxylated monomer include hydroxylated vinyl ethers such as 2-hydroxyethylvinyl ether, 3-hydroxypropylvinyl ether, 2-hydroxypropylvinyl ether, 2-hydroxy-2-methylpropylvinyl ether, 4-hydroxybutylvinyl ether, 4-hydroxy-2-methylbutylvinyl ether, 5-hydroxypentylvinyl ether, and 6-hydroxyhexylvinyl ether; and hydroxylated allyl ethers such as 2-hydroxyethylallyl ether, 4-hydroxybutylallyl ether, and glycerol monoallyl ether. Among these, hydroxylated vinyl ethers, especially 4-hydroxybutylvinyl ether and 2-hydroxyethylvinyl ether are preferred, because these are excellent in polymerization reactivity and curability achieved functional groups.

Examples of other hydroxylated monomers include hydroxyalkyl esters of (meth)acrylic acid such as 2-hydroxyethyl acrylate and 2-hydroxyethyl methacrylate.

Examples of fluoropolymers to which a hydroxyl group is introduced include the following polymers, in terms of a constitutional unit.

(1) Perfluoroolefin polymers which mainly contain a perfluoroolefin unit: examples thereof include a homopolymer of tetrafluoroethylene (TFE), a copolymer of TFE and hexafluoropropylene (HFP), perfluoro(alkylvinyl ether) (PAVE), and/or the like, and a copolymer of these and other copolymerizable monomers.

Examples of other copolymerizable monomers include, but are not limited to, carboxylic acid vinyl esters such as vinyl acetate, vinyl propionate, vinyl butyrate, vinyl isobutyrate, vinyl pivalate, vinyl caproate, vinyl versatate, vinyl laureate, vinyl stearate, vinyl cyclohexyl carboxylate, vinyl benzoate, and vinyl para-t-butyl benzoate; alkylvinyl ethers such as methyl vinyl ether, ethyl vinyl ether, butyl vinyl ether, and cyclohexyl vinyl ether; non-fluoroolefins such as ethylene, propylene, n-butene, and isobutene; and fluoromonomers such as vinylidene fluoride (VdF), chlorotrifluoroethylene (CTFE), vinyl fluoride (VF), and fluorovinyl ether.

Among these, TFE polymers that mainly contain TFE are preferred, because these are excellent in pigment dispersibility, weather resistance, copolymerizability, and chemical resistance.

Specific examples of hydroxylated perfluoroolefin polymers include copolymers of TFE/isobutylene/hydroxybutyl vinyl ether/other monomers, copolymers of TFE/vinyl versatate/hydroxybutyl vinyl ether/other monomers, and copolymers of TFE/VdF/hydroxybutyl vinyl ether/other monomers. Especially, copolymers of TFE/isobutylene/hydroxybutyl vinyl ether/other monomers, copolymers of TFE/vinyl versatate/hydroxybutyl vinyl ether/other monomers, and the like are preferred.

Examples of curable TFE polymer coating compositions include (ZEFFLE GK series produced by Daikin Industries, Ltd.

(2) CTFE polymers mainly containing a chlorotrifluoroethylene (CTFE) unit : specific examples thereof include a copolymer of CTFE/hydroxybutyl vinyl ether/other monomers.

Examples of a curable CTFE polymer coating composition include LUMIFLON produced by Asahi Glass Co., Ltd., FLUONATE produced by DIC Corporation, CEFRAL COAT produced by Central Glass Co., Ltd., and ZAFLON produced by TOAGOSEI CO., LTD.

(3) VdF polymer mainly containing a vinylidene fluoride (VdF) unit: examples thereof include a copolymer of VdF/TFE/hydroxybutyl vinyl ether/other monomers.

(4) Fluoroalkylated polymer mainly containing a fluoroalkyl unit: for example, a copolymer of CF₃CF₂(CF₂CF₂)ₙCH₂CH₂OCOCH=CH₂ (a mixture of n=3 and n=4) / 2-hydroxyethyl methacrylate/stearyl acrylate.

Examples of fluoroalkylated polymers include UNIDYNE, Ftone, produced by Daikin Industries, Ltd., and Zonyl produced by Du Pont.

Among these, a perfluoroolefin polymer is preferred, considering weather resistance and moisture-proof property.

The hydroxyl value of the hydroxylated fluoropolymer is preferably 5 to 100 mgKOH/g, and more preferably 35 to 100 mgKOH/g. A hydroxyl value smaller than 5 mgKOH/g leads to inferior curing reactivity. A hydroxyl value greater than 100 mgKOH/g leads to a problem of inferior solubility in a solvent.

An important feature of the present invention is that silicon oxide (silica) particles having a specific average primary-particle diameter are mixed to the coating composition.

Silicon oxide particles used in the present invention have an average primary-particle diameter of 0.1 to 30 µm. If the average primary-particle diameter is smaller than 0.1 µm, pressure bonding of the films is less likely to be prevented. The lower limit is preferably 0.5 µm, and is more preferably 1.0 µm. If the average primary-particle diameter is greater than 30 µm, depending on the thickness of the cured coating film layer, there may be reduction in coating properties such as deterioration in preservation stability and flaking of coating. The upper limit is preferably 10.0 µm, and is more preferably 5.0 µm. Examples of methods of measuring the average primary-particle diameter include method using a laser diffraction particle analyser.

Types of silicon oxide particles are not particularly limited, and may be synthetic silica particles which are synthesized by the wet method or dry method, or natural silica particles such as silica sand and diatomaceous earth.

The surface of the silicon oxide particles may be hydrophilic or hydrophobized. Also the particles may or may not have pores inside.

Specific examples of the silicon oxide particles include colloidal silica, dry silica, wet silica, silica gel, precipitated silica, and fumed silica. Examples of commercially available silicon oxide particles include IPA -ST, IPA-ST L, and IPA-ST ZL (trade name) produced by Nissan Chemical Industries. Ltd.; and Sylysia, Sylophobic, and Sylosphere series (trade name) produced by Fuji Silysia Chemical Ltd.

The amount of silicon oxide particles is preferably 0.1 to 100 parts by mass for 100 parts by mass of the hydroxylated fluoropolymer, in terms of good weather resistance. A reduced amount of silicon oxide particles tend to cause reduction in secondary adhesion, pressure bonding prevention effect, and usable life of coating composition. Too large an amount of silicon oxide particles tends to cause reduced mechanical strength of the coating film and increased difficulty in application due to increased viscosity. The amount of the silicon oxide particles is preferably 1 part by mass or more, and is more preferably 5 parts by mass or more, for 100 parts by mass of the hydroxylated fluoropolymer. Also, the amount of the silicon oxide particles is preferably 50 parts by mass or less, and is more preferably 35 parts by mass or less.

The coating composition for the weatherable backsheet for solar cell modules may contain a color pigment to achieve aesthetic appearance of the solar cell module and to protect the water-impermeable sheet from ultraviolet rays. Especially, titanium oxide, calcium carbonate, which are a white pigment, carbon black, which is a black pigment, and composite metals such as a Cu-Cr-Mn alloy are usually mixed.

The amount of the pigment is preferably 60 to 300 parts by mass for 100 parts by mass of the abode-mentioned hydroxylated fluoropolymer, and is more preferably 80 to 200 parts by mass.

The coating composition may contain various additives and resins, according to the required properties. Examples of the additives include defoamers, leveling agents, UV absorbers, light stabilizers, thickeners, adhesion enhancing agents, delusterants, and flame retardants. Examples of the resins include acrylic resins, epoxy resins, ABS resins, melamine resins, polyurethane, polyethylene, polystyrene polypropylene, and polyvinyl acetate.

A coating composition containing a hydroxylated fluoropolymer as a film forming component and specific silicon oxide particles can be prepared into a solvent coating composition, water-soluble coating composition, or powder coating composition, by a usual method. Among these, the solvent coating composition is preferred in terms of easy film formation, favorable curability, and favorable drying property.

In the case that the coating composition is prepared into a solvent coating composition, examples of organic solvents include ester solvents such as butyl acetate and ethyl acetate; alcohol solvents such as isopropanol and butanol; ketone solvents such as methyl ethyl ketone and methyl isobutyl ketone; and aromatic solvents such as toluene and xylene.

If an inorganic material such as a pigment is mixed, there is a problem that the pigment precipitates and aggregates with time, causing a film defect. However, if the above-mentioned specific silicon oxide particles are mixed, the precipitation and aggregation of the pigment is suppressed. If the pigment precipitates, it is easily redispersed. Thus, the stability of the coating is improved.

In the present invention, a curing agent and, if necessary, a curing aid is added to a hydroxylated fluoropolymer so as to provide a curable coating composition.

The curing agent may be any of the compounds which cross-link with a hydroxylated fluoropolymer. Examples thereof include isocyanate curing agents and amine curing agents. Preferred among these are isocyanate curing agents, because they are easily available, cross-linkable at temperatures ranging from normal temperature to 150°C, and produce no byproducts. Examples of the isocyanate agents include, but are not limited to, 2,4-tolylene diisocyanate, diphenylmethane-4,4'-diisocyanate, xylylene diisocyanate, isophorone diisocyanate, lysine methyl ester diisocyanate, methyl cyclohexyl diisocyanate, trimethylhexamethylene diisocyanate, hexamethylene diisocyanate, n-pentane-1,4-diisocyanate, trimers thereof, adducts thereof, biurets thereof, polymers thereof which have 2 or more of isocyanate groups, and blocked isocyanates.

The amount of the curing agent is preferably 0.5 to 1.5 equivalents for 1 equivalent of a hydroxyl group in the hydroxylated fluoropolymer, and is more preferably 0.7 to 1.3 equivalents.

The curing aid is not particularly limited, and may be an organometallic curing aid, for example. Examples of the organometallic curing aid include organotitanium curing aids, organotin curing aids, organozinc curing aids, organozirconium curing aids, organocobalt curing aids, and organolead curing aids. Especially, the curing aid is preferably one selected from the group consisting of organotitanium curing aids, organozirconium curing aids, and organozinc curing aids, from the viewpoint of dispersibility, stability, availability, and the like.

Examples of the organotitanium curing aids include titanium tetraisopropoxide, titanium tetranormal butoxide, titanium butoxide dimer, titanium tetra-2-ethylhexoxide, titanium diisopropoxy bis(acetyl acetonate), titanium tetraacetyl acetonate, titanium dioctyloxy bis(octylene glycolate), titanium diisopropoxybis(ethyl acetoacetate), titanium diisopropoxy bis(triethanol aminate), titanium lactate ammonium salt, titanium lactate, and polyhydroxy titanium stearate. Examples of the organozirconium curing aids include zirconium tetranormal propoxide, zirconium tetranormal butoxide, zirconium tetraacetyl acetonate, zirconium tributoxy monoacetylacetonate, zirconium monobutoxy acetylacetonate bis(ethylacetoacetate), zirconium dibutoxy bis(ethylacetoacetate), zirconium tetraacetylacetonate, zirconium tributoxy monostearate. Examples of the organozinc curing aids include zinc acrylate, zinc acetate, zinc citrate, zinc salicylate, zinc oxalate, zinc adipate, zinc carbamate, zinc phthalocyanine, zinc thiolate, zinc stearate, zinc naphthenate, zinc decanoate, zinc butyrate, zinc neodecanoate, zinc isobutyrate, zinc benzoate, zinc octoate, and zinc 2-ethylhexane.

The amount of the organometallic curing aid is preferably 10 mole or less, more preferably 0.001 to 10 mole, further more preferably 0.2 to 2.0 mole, and especially preferably 0.4 to 1.0 mole for 1 mole of -NCO group in the isocyanate curing agent.

The curable coating composition which contains a curing agent has an applicable time (usable life or pot life), since the blended curing agent causes a gradual curing reaction. Longer usable life makes application easier. Instead, drying and curing take longer, resulting in a reduced productivity. However, if the above-mentioned specific silicon oxide particles are mixed, surprisingly, the curable coating composition has a greatly prolonged usable life without affecting drying time and curing time. The reason for this is unknown, but is considered that the curing agent is trapped in a pore structure in the specific silicon oxide particles to prolong the usable life, and the trapped curing agent is released from the pore structure by heating during thermal curing.

The water-impermeable sheet on which the cured coating film layer is formed is applied so as to prevent moisture from penetrating to EVA, which is a sealant, or solar cell. Any of the materials which are substantially impermeable to water can be used for this sheet. Examples of the often used materials include polyester resin sheets such as a polyethylene terephthalate (PET) sheet and a polyethylene naphthalate sheet; polyorefin resin sheets such as a polyethylene sheet and a polypropylene sheet; polyurethane resin sheets, polycarbonate resin sheets, polyamide resin sheets, polystyrene resin sheets, polyacrylonitrile rein sheets, polyvinyl chloride resin sheets, polyvinyl acetal resin sheets, polyvinyl butyral resin sheets, fluororesin sheets, Si-deposited products of the above-mentioned resin sheets such as an Si-deposited PET sheet, and metallic thin sheets such as an aluminum sheet and a stainless steel sheet, in terms of weight, price, and flexibility. Among these, an Si-deposited PET sheet is especially often used. The thickness is about 10 to 250 µm.

In order to improve the adhesion with the cured coating film layer, the water-impermeable sheet may be subjected to a conventionally known surface treatment. Examples of the surface treatment include corona discharge treatment, plasma discharge treatment, and conversion treatment. In the case of a metallic sheet, blasting may be performed, for example.

A cured coating film layer is formed to the water-impermeable sheet by applying a coating composition containing a hydroxylated fluoropolymer, specific silicon oxide particles, and a curing agent on at least one surface of the sheet, curing (incompletely curing) the resultant coating film, rolling the resultant laminate, and aging (completely curing) the incompletely cured coating film of the rolled laminate, depending on the forms of the coating compositions. Thus, the weatherable backsheet of the present invention is manufactured.

Specifically, for example, the weatherable backsheet is manufactured by the manufacturing step including steps of: applying a coating composition containing a hydroxylated fluoropolymer and specific silicon oxide particles on the surface of the water-impermeable sheet so as to provide an uncured coating film layer (application step); curing the uncured coating film layer so that the degree of cross-linking may be 80% to 99% to provide a laminate including the water-impermeable sheet and the cured coating film (curing and laminating step); rolling the laminate (rolling step); and curing the cured coating film of the rolled laminate completely (aging step).

In the application step, a coating composition containing a hydroxylated fluoropolymer and specific silicon oxide particles are applied on the surface of a water-impermeable sheet so as to provide an uncured coating film layer. The application temperatures may be within temperatures for usual application conditions.

As for the application to the water-impermeable sheet, direct application to the water-impermeable sheet is preferred. This results in excellent adhesion.

Also, the curable coating composition may be applied to a primer layer and the like formed on the water-impermeable sheet. The primer layer is formed by a usual method, using a conventionally known coating composition for primer. Representative examples of the coating composition for primer include an epoxy resin, a urethane resin, an acrylic resin, a silicone resin, and a polyester resin. The cured coating film layer which is formed by the coating composition containing hydroxylated fluoropolymer and specific silicon oxide particles used in the present invention has an excellent adhesion to such a primer layer.

In the curing and laminating step, the uncured coating film layer is cured so that the degree of cross-linking may be in the range of 80% to 99% to provide a laminate including a water-impermeable sheet and a cured coating film. Considering the efficiency of the continuos manufacturing line, the cured coating layer is put into the incompletely cured state in which the degree of cross-linking is adjusted in the range of 80% to 99%.

In the case of the solvent coating composition, the uncured coating film layer can be cured at temperatures ranging from 10°C to 300°C, and is generally cured at a normal temperature (20°C to 30°C). Thus, materials for which a treatment at a high temperature should be avoided such as an Si-deposited PET sheet can be used as a water-impermeable sheet without causing problems.

In the rolling step, generally, a step of rolling the laminate in an incompletely cured state (rolling step) is adopted. In the rolling step, a tack on the coating film in an incompletely cured state may cause a problem of blocking (press bonding) of the back surface of the water-impermeable sheet 5 and a coating film 7 while the laminate is rolled, as illustrated in Fig. 8.

This problem of blocking (press bonding) also arises when a hydroxylated fluoropolymer coating composition is used, as disclosed in Patent Literatures 3 and 4. However, it is found that addition of specific silicon oxide particles to a hydroxylated fluoropolymer improves blocking resistance (pressure bonding resistance).

For example, the back surface of the water-impermeable sheet and the free surface of the cured coating film having a degree of cross-linking of 80% to 99%, which contact each other when the laminate is rolled in the rolling step in the manufacturing of the weatherable backsheet for solar cell modules of the present invention, did not stick together after a load of 0.08 MPa is applied for 24 hours in a blocking resistance test based on JIS K5600-3-5. Here, as shown in the blocking resistance evaluation in Examples described below, "not stick together" means that the coating film and the water-impermeable sheet are separated spontaneously, that they are separated when a slight force is applied, or that they are separated when a force is applied and the surface of the coating is slightly disordered.

In the aging step, the cured coating film of the rolled laminate is completely cured. In this step, Examples of the method of completely curing the cured coating film include a method in which the cured coating film is aged in a furnace at 40°C for 48 hours.

In the backsheet of the present invention thus obtained, the cured coating film layer preferably has a thickness of 3 µm or greater, more preferably 5 µm or greater, and especially preferably 10 µm or greater, in terms of favorable hiding, weather resistance, chemical resistance, and moisture-proof property. The upper limit of the thickness is preferably about 1000 µm or smaller, and more preferably 100 µm or smaller, because too large thickness leads to a loss of weight saving effect. The film thickness is especially preferably 5 to 40 µm.

In the following, the solar cell module of the present invention is described.

The solar cell module of the present invention is a laminate including a sealant layer which has a solar cell sealed inside and contains an ethylene/vinyl acetate copolymer and the above-mentioned weatherable backsheet. The solar cell module has a laminate structure in which a cured coating film layer is interposed between the sealant layer and the water-impermeable sheet of the weatherable backsheet.

The solar cell module of the present invention is a laminate including a sealant layer which has a solar cell sealed inside and contains an ethylene/vinyl acetate copolymer and the above-mentioned weatherable backsheet. The solar cell module has a laminate structure in which a water-impermeable sheet is interposed between the sealant layer and a cured coating film layer of the weatherable backsheet.

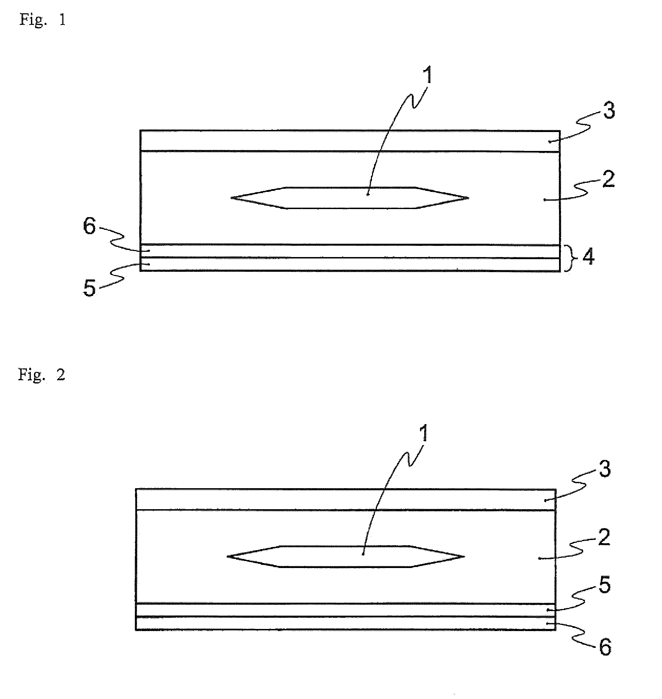

A favorable embodiment of the solar cell module of the present invention is described based on Fig. 1. Figs. 2 to 5 are schematic cross-sectional views of the solar cell module according to other favorable embodiments of the present invention.

In Fig. 1, the symbol 1 indicates a solar cell, which is sealed by a sealant layer 2 represented by EVA. The sealant layer 2 is sandwiched between a surface layer 3 and a weatherable backsheet 4. The weatherable backsheet 4 contains a water-impermeable sheet 5 and a cured coating film layer 6 of a hydroxylated fluoropolymer coating composition. In this first embodiment, the cured coating film layer 6 is formed on the sealant (EVA) layer 2 side.

In this embodiment, since the cured coating film layer 6 contacts EVA, the interfacial adhesion is improved especially due to the co-cross-linking with EVA.

Fig. 2 illustrates the second embodiment. A cured coating film layer 6 is formed on the opposite side of a sealant (EVA) layer 2. In the case of this embodiment, the cured coating film layer 6 leads to an excellent weather resistance. In order to improve the adhesion, the sealant (EVA) layer 2 side of the water-impermeable sheet 5 is preferably subjected to a surface treatment. As necessary, a polyester adhesive, an acrylic adhesive, a urethane adhesive, an epoxy adhesive, or the like may be used.

The weatherable backsheet of the present invention may have a two-layer structure in which a cured coating film layer 6 is formed on only one side of the above-mentioned water-impermeable sheet 5 (Figs. 1 and 2), or a three-layer structure described below.

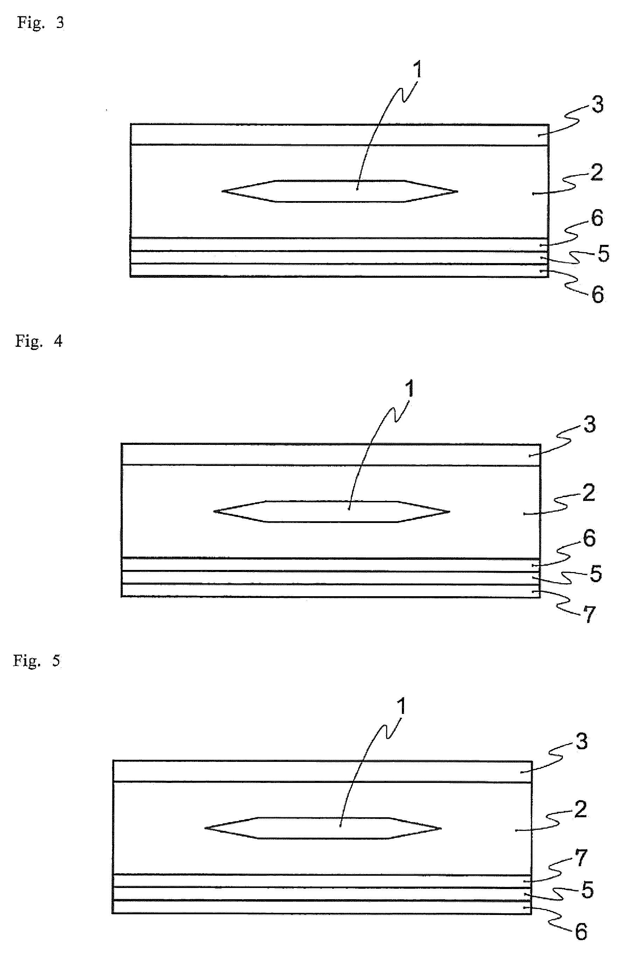

Fig. 3 illustrates an embodiment of the three-layer weatherable backsheet (the third embodiment). The weather-resistant sheet according to the third embodiment has a three-layer structure in which a cured coating film layer 6 of a hydroxylated fluoropolymer coating composition is formed on both sides of the water-impermeable sheet 5.

The third embodiment is inferior in some measure, from the viewpoint of the film thickness of the weatherable backsheet. However, the third embodiment has advantages of both the first embodiment and the second embodiment.

Also, the three-layer weatherable backsheet may have a three-layer structure in which a cured coating film layer of a hydroxylated fluoropolymer coating composition is formed on one side of the water-impermeable sheet; and a cured coating film layer of a fluoropolymer coating composition which has no curable functional group, a fluoropolymer sheet, a polyester sheet, or a coating film of a polyester coating composition (other sheet or coating film) is formed on the other side (Figs. 4 and 5).

The weatherable backsheet according to the fourth embodiment (Fig. 4) has a structure in which the coating film 7 is formed on the opposite side of the sealant (EVA) layer 2 of the first embodiment. The weatherable backsheet according to the fifth embodiment (Fig. 5) has a structure in which the coating film 7 is formed on the sealant (EVA) layer 2 side of the second embodiment.

In both the fourth and fifth embodiments, the material for the coating layer 7 may be a cured coating film layer containing a fluoropolymer coating composition which has no curable functional group, a fluoropolymer sheet, a polyester sheet, or a coating film of polyester coating composition.

Examples of the cured coating film layer of the fluoropolymer coating composition which has no curable functional group include a cured coating film layer of a coating composition prepared by adding a tetraalkoxysilane or a partial hydrolysate thereof to PVdF disclosed in Patent Literature 2, a cured coating film layer which of a coating composition prepared by mixing of a VdF/TFE/CTFE copolymer and an alkoxysilane unit-containing acrylic resin, a cured coating film layer of a coating composition prepared by mixing of a VdF/TFE/HFP copolymer and a hydroxylated acrylic resin, and a cured coating film layer of a coating composition prepared by adding an aminosilane coupling agent to a VdF/HFP copolymer. Generally, the film thickness is preferably 5 to 300 µm, more preferably 10 to 100 µm, and especially preferably 10 to 50 µm, in terms of favorable hiding, weather resistance, chemical resistance, and moisture-proof resistance. Also in this case, the curable coating composition may be applied on a primer layer and the like formed on the weatherable backsheet.

Examples of the fluoropolymer sheet include fluoropolymer sheet used for usual weatherable backsheets such as a PVdF sheet, a PVF sheet, a PCTFE sheet, a TFE/HFP/ethylene copolymer sheet, a TFE/HFP copolymer (FEP) sheet, a TFE/PAVE copolymer (PFA) sheet, an ethylene/TFE copolymer (ETFE) sheet, and an ethylene/CTFE copolymer (ECTFE) sheet. Generally, the film thickness is preferably 5 to 300 µm, more preferably 10 to 100 µm and especially preferably 10 to 50 µm, in terms of favorable weather resistance.

As polyester sheets, ones used in the conventional weatherable backsheets can be used. The polyester sheet can be bonded to the water-impermeable sheet 5 with an acrylic adhesive, a urethane adhesive, an epoxy adhesive, a polyester adhesive, or the like. Generally, the film thickness is preferably 5 to 300 µm, more preferably 10 to 100 µm, and especially preferably 10 to 50 µm, in terms of favorable weather resistance, favorable transparency, and low cost.

Examples of the polyester coating composition include one containing a saturated polyester resin that contains a polyvalent carboxylic acid and a polyvalent alcohol and the like, and one containing an unsaturated polyester resin which contains glycols such as maleic anhydride and fumaric acid. A coating method such as roll coating, curtain coating, spray coating, and die coating is used to form a coating film. The film thickness is preferably 5 to 300 µm, more preferably 10 to 100 µm, and especially preferably 10 to 50 µm, in terms of favorable hiding, weather resistance, chemical resistance, and moisture-proof resistance. Also in this case, the curable coating composition may be applied on a primer layer and the like formed on the weatherable backsheet.

In the following, the solar panel of the present invention is described.

The solar panel of the present invention includes the above-mentioned solar cell module. The solar panel may have a structure in which solar cell modules are arranged to form a matrix in the vertical direction, in the lateral direction, or in a radial direction or take other conventionally known structure. The structure of the solar panel is not particularly limited.

### EXAMPLES

In the following, the present invention is described based on preparations and examples. However, the present invention is not limited to the preparations and examples.

Test methods and measurement methods used in the preparations and examples and the like are described below.

### (Pigment dispersion stability)

The measurement was carried out in accordance with JIS K 5600-2-7. The white coating compositions and clear coating compositions prepared in the preparations were each placed in a 50 ml polypropylene vessel. The vessel was closed and allowed to stand at a room temperature and 50°C. Time required for the pigment to start to sink to the bottom of the vessel was measured.

### (Usable life)

The measurement was carried out in accordance with JIS K5600-2-6. The curable coating compositions prepared in the preparations were each placed in a 100 ml polypropylene vessel. The vessel was closed and then allowed to stand at 25°C. After that, the viscosity was timely measured. Time it took for the viscosity to reach twice the initial viscosity was measured as usable life.

### (Thickness of coating film)

In accordance with JIS C-2151, the thickness of the coating film is measured with a micrometer film thickness meter.

### (Blocking resistance)

The test was carried out in accordance with JIS K5600-3-5. The prepared coating composition was applied to 50 mm × 100 mm PET films. The coating was dried by heating in a drier (SPHH-400, produced by Espec Corp.) at 120°C for 2 minutes. Then, the test samples were taken and allowed to cool to room temperature. The test samples were sandwiched by glass sheets so that the coated surface of one of the test samples can contact the uncoated surface of another test sample in a 50 mm × 50 mm area. Then, a pressure of 0.08 MPa was applied to the contact area at 60°C for 24 hours by placement of a 20 kg weight on the glass sheets. The two films were allowed to cool to room temperature and then pulled from both sides. The blocking resistance was evaluated by the condition of the films when being pulled. Evaluation standards are as follows:
+++: The films are separated spontaneously, or separated when a slight force is applied;
++: The films are separated when a force is applied and the surface of the coating is disturbed slightly;
+: The films are separated when a force is applied, and the surface of the coating is disturbed; and
-: The films are not separated when a force is applied.

### (Primary adhesion)

The cross cut test (1 mm × 1 mm × 100 squares) was performed in accordance with JIS K5600-5-6, and the primary adhesion was evaluated by the number of the remaining squares.

### (Secondary adhesion)

A test sample was placed into a thermo-hygrostat (temperature 85°C, relative humidity: 85%) and allowed to stand for 2000 hours. After that, the test sample was taken out and subjected to the cross cut test (1 mm × 1 mm × 100 squares) in accordance with JIS K5600-5-6. The secondary adhesion was evaluated by the number of the remaining squares.

### Preparation 1

191.9 g of a hydroxylated TFE copolymer composition (ZEFFLE GK570, a 65% by mass solution of a hydroxylated TFE copolymer in butyl acetate, hydroxyl value: 60 mgKOH/g, produced by Daikin Industries. Ltd.), 249.9 g of titanium oxide (D918, produced by Sakai Chemical Industry Co., Ltd.) as a white pigment, and 158.7 g of butyl acetate were premixed under stirring. Then 779 g of 1.2 mm diameter glass beads were added to the resultant mixture and dispersed with a pigment disperser for 1 hour under at 1500 rpm. The glass beads were filtered with a #80 mesh sieve. To the resultant solution were added 268.8 g of a hydroxylated TFE copolymer (ZEFFLE GK570), 80.7 g of butyl acetate, and 50.0 g of silica dioxide (Sylysia 436, average primary-particle diameter: 3.4 µm, produced by Fuji Silysia Chemical Ltd.). The resultant mixture was stirred with a homodisper for 10 minutes at 1500 rpm to provide a white coating composition 1. This white coating composition 1 was subjected to the measurement of pigment dispersion stability. Table 1 shows the result. Here, the average primary-particle diameter of the silica dioxide was measured with a laser diffraction particle size analyzer.

A curable coating composition 1 was prepared by adding 6.2 parts by mass of an isocyanate curing agent (Sumidur N3300, produced by Sumika Bayer Co., Ltd.) to 100 parts by mass of the white coating composition 1. The curable coating composition 1 was subjected to the measurement of usable life. Table 1 shows the result.

### Preparation 2

A clear coating composition 1 was prepared by stirring a mixture of 710.1 g of a hydroxylated TFE copolymer composition (ZEFFLE GK570), 213.0 g of butyl acetate, and 76.9 g of silica dioxide (Sylysia 436, produced by Fuji Silysia Chemical Ltd.) with a homodisper for 10 minutes at 1500 rpm. The clear coating 1 was subjected to the measurement of pigment dispersion stability. Table 1 shows the result.

A curable coating composition 2 was prepared by adding 10.2 parts by mass of an isocyanate curing agent (Sumidur N3300, produced by Sumika Bayer Co., Ltd.) to 100 parts by mass of the clear coating composition 1. The curable coating composition 2 was subjected to the measurement of usable life. Table 1 shows the result.

### Preparation 3 (comparison)

202.0 g of a hydroxylated TFE copolymer composition (ZEFFLE GK570), 263.0 g of titanium oxide (D918, produced by Sakai Chemical Industry Co., Ltd.) as a white pigment, and 167.0 g of butyl acetate were premixed under stirring. Then 820 g of 1.2 mm diameter glass beads were added to the resultant mixture and dispersed with a pigment disperser at 1500 rpm for 1 hour. The glass beads were filtered with a #80 mesh sieve. To the resultant solution were added 283.0 g of a hydroxylated TFE copolymer (ZEFFLE GK570), and 85.0 g of butyl acetate so as to provide a white coating composition 2. This white coating composition 2 was subjected to the measurement of pigment dispersion stability. Table 1 shows the result.

A curable coating composition 3 for comparison was prepared by adding 6.5 parts by mass of an isocyanate curing agent (Sumidur N3300, produced by Sumika Bayer Co., Ltd.) to 100 parts by mass of the white coating composition 2. The curable coating composition 3 for comparison was subjected to the measurement of the usable life. Table 1 shows the result.

### Preparation 4 (comparison)

A clear coating composition 2 was prepared by stirring a mixture of 769.2 g of a hydroxylated TFE copolymer composition (ZEFFLE GK570) and 230.8 g of butyl acetate. The clear coating composition 2 was subjected to the measurement of pigment dispersion stability. Table 1 shows the result.

A curable coating composition 4 for comparison was prepared by adding 10.2 parts by mass of an isocyanate curing agent (Sumidulr N3300, produced by Sumika Bayer Co., Ltd.) to 100 parts by mass of the clear coating composition 2. The curable coating composition 4 was subjected to the measurement of usable life. Table 1 shows the result.

### Example 1

A two-layer weatherable backsheet 1 was produced by applying the curable coating composition 1 prepared in Preparation 1 on one surface of a PET sheet (Lumirror S10, thickness 125 µm, produced by Toray Industries, Inc.) used as a water-impermeable sheet so that the dry coating film thickness may be 10 µ and drying at 120°C for 2 minutes.

This weatherable backsheet 1 was evaluated for blocking resistance (between coating film and sheet), primary adhesion, and secondary adhesion. Table 1 shows the results.

### Example 2

A two-layer weatherable backsheet 2 was produced by applying the curable coating composition 2 prepared in Preparation 2 on one surface of a PET sheet (Lumirror S10, thickness 125 µm, produced by Toray Industries, Inc.) used as a water-impermeable sheet so that the dry coating film thickness may be 10 µ and drying at 120°C for 2 minutes.

This weatherable backsheet 2 was evaluated for blocking resistance (between coating film and sheet), primary adhesion, and secondary adhesion. Table 1 shows the results.

### Comparative Example 1

A two-layer weatherable backsheet 3 was produced by applying the curable coating composition 3 prepared in Preparation 3 on one surface of a PET sheet (Lumirror S10, thickness 125 µm, produced by Toray Industries, Inc.) used as a water-impermeable sheet so that the dry coating film thickness may be 10 µ and drying at 120°C for 2 minutes.

This weatherable backsheet 3 was evaluated for blocking resistance (between coating film and sheet), primary adhesion, and secondary adhesion. Table 1 shows the results.

### Comparative Example 2

A two-layer weatherable backsheet 4 was produced by applying the curable coating composition 4 prepared in Preparation 4 on one surface of a PET sheet (Lumirror S10, thickness 125 µm, produced by Toray Industries, Inc.) used as a water-impermeable sheet so that the dry coating film thickness may be 10 µ and drying at 120°C for 2 minutes.

This weatherable backsheet 4 was evaluated for blocking resistance (between coating film and sheet), primary adhesion, and secondary adhesion. Table 1 shows the results.

**[Table 1]**

| | | Example 1 | Comparative Example 1 | Example 2 | Comparative Examples 2 |
|---|---|---|---|---|---|
| Coating compositions | | White coating composition 1 | White coating composition 2 | Clear coating composition 1 | Clear coating composition 2 |
| | Pigment dispersion stability (at room temperature, day) | 180 or more | 20 | | |
| | Pigment dispersion stability (50°C, day) | 180 or more | 15 | | |

| Curable coating compositions | | Curable coating composition 1 | Curable coating composition 2 | Curable coating composition 3 | Curable coating composition 4 |
|---|---|---|---|---|---|
| | Usable life (hour) | 39 | 6 | 30 | 4 |

| Backsheet | | Backsheet 1 | Backsheet 3 | Backsheet 2 | Backsheet 4 |
|---|---|---|---|---|---|
| | Primary adhesion | 100/100 | 100/100 | 100/100 | 100/100 |
| | Secondary adhesion | 100/100 | 90/100 | 100/100 | 90/100 |
| | Blocking resistance | +++ | + | +++ | + |

Table 1 indicaes that, comparing the weatherable backsheet 1 produced in Example 1 and the weatherable backsheet 3 produced in Comparative Example 1, the backsheet 1 is superior in secondary adhesion, while it has the same primary adhesion as the backsheet 3. The backsheet 1 is also superior in blocking resistance, pigment dispersion stability, and usable life of the coating composition.

Further, Table 1 indicates that, comparing the weatherable backsheet 2 produced in Example 2 and the weatherable backsheet 4 produced in Comparative Example 2, the backsheet 2 is superior in secondary adhesion, while it has the same primary adhesion as the backsheet 4. The backsheet 2 is also superior in blocking resistance and usable life of the coating composition.

### REFERENCE SIGNS LIST

| | |
|---|---|
| 1 | Solar cell |
| 2 | Sealant layer |
| 3 | Surface layer |
| 4 | Weatherable backsheet |
| 5 | Water-impermeable sheet |
| 6 | Cured coating film layer |
| 7 | Sheet or coating film |
| 8,9 | Protective layer |
| 10 | Backsheet |

## Claims

1. A weatherable backsheet for a solar cell module, comprising:
a water-impermeable sheet; and
a cured coating film layer disposed on at least one surface of the water-impermeable sheet,
wherein the cured coating film comprising a cross-linked product of a coating composition which comprises a hydroxylated fluoropolymer and silicon oxide particles which have an average primary-particle diameter of 0.1 to 30 µm.

2. The backsheet according to claim 1,
wherein the amount of the above-mentioned silicon oxide particles is 0.1 to 100 parts by mass for 100 parts by mass of the hydroxylated fluoropolymer in the coating composition.

3. The backsheet according to claim 1 or 2,
wherein the above-mentioned coating composition further comprises an isocyanate curing agent.

4. A solar cell module which is a laminate comprising:
a sealant layer that seals a solar cell and contains an ethylene/vinyl acetate copolymer; and
the weatherable backsheet according to any one of claim 1, 2, and 3.

5. The solar cell module according to claim 4,
wherein the above-mentioned cured coating film layer is interposed between the sealant layer and the water-impermeable sheet.

6. The solar cell module according to claim 4,
wherein the above-mentioned water-impermeable sheet is interposed between the sealant layer and the above-mentioned cured coating film layer.

7. A solar panel, comprising the solar cell module according to any one of claim 4, 5, and 6.
